Europäisches Patentamt

European Patent Office

Office européen des brevets

(19)

(11) **EP 0 453 610 B1**

(12) **EUROPÄISCHE PATENTSCHRIFT**

(45) Veröffentlichungstag und Bekanntmachung des Hinweises auf die Patenterteilung:
**26.06.1996  Patentblatt 1996/26**

(51) Int Cl.6: **G03F 7/039**, G03F 7/38

(21) Anmeldenummer: **90108062.2**

(22) Anmeldetag: **27.04.1990**

(54) **Verfahren zur Erzeugung einer Reseststruktur**

Process for obtaining resist structures

Procédé pour réaliser des structures de réserve

(84) Benannte Vertragsstaaten:
**BE DE FR GB IT NL**

(43) Veröffentlichungstag der Anmeldung:
**30.10.1991  Patentblatt 1991/44**

(73) Patentinhaber: **SIEMENS AKTIENGESELLSCHAFT
D-80333 München (DE)**

(72) Erfinder:
  • **Sezi, Recai, Dr., Dipl.-Chem.
D-8551 Röttenbach (DE)**
  • **Borndörfer, Horst, Dipl.-Chem.
D-8520 Erlangen (DE)**
  • **Rissel, Eva-Maria
D-8550 Forchheim (DE)**
  • **Leuschner, Rainer, Dr., Dipl.-Chem.
D-8521 Grossenseebach (DE)**
  • **Sebald, Michael, Dr., Dipl.-Chem.
D-8521 Hessdorf (DE)**
  • **Ahne, Hellmut, Dr., Dipl.-Chem.
D-8551 Röttenbach (DE)**
  • **Birkle, Siegfried, Dr., Dipl.-Chem.
D-8552 Höchstadt (DE)**

(56) Entgegenhaltungen:
EP-A- 249 769          EP-A- 394 740
EP-A- 0 234 327        EP-A- 0 251 241
EP-A- 0 291 994        EP-A- 0 292 821

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 453 610 B1

**Beschreibung**

Die Erfindung betrifft ein Verfahren zur Erzeugung einer hochaufgelösten Resiststruktur mit steilen Flanken.

Die Erzeugung von Resiststrukturen spielt insbesondere in der Mikroelektronik eine wichtige Rolle, beispielsweise bei der Herstellung von Halbleiterbauelementen; dazu dienen Photoresists, die auf photolithographischem Weg strukturiert werden. Die fortschreitende Entwicklung in der Mikroelektronik bringt nun aber eine Zunahme der Integrationsdichte mit sich, und bei immer kleiner werdenden Strukturen werden auch an die Strukturerzeugung immer höhere Ansprüche gestellt. Dabei ist insbesondere eine zunehmend höhere Auflösung bzw. ein zunehmend höherer Kontrast der verwendeten Photoresists erforderlich.

Bei der Strukturierung von Photoresists auf photolithographischem Weg bestimmen - neben technologischen und resistspezifischen Parametern - auch Eigenschaften der zur Belichtung verwendeten Stepper bzw. der Stepperlinse die erreichbare minimale Strukturgröße CD (= Critical Dimension) sowie die Tiefenschärfe DOF (= Depth of Focus). Die stepperspezifischen Einflußgrößen Belichtungswellenlänge $\lambda$ und numerische Apertur NA (der Linse) stehen mit CD und DOF in folgendem Zusammenhang:

$$CD = f_1 \ (\lambda/NA)$$

und

$$DOF = \pm f_2 \ (\lambda/NA^2);$$

$f_1$ und $f_2$ stellen dabei verfahrens- bzw. anlagespezifische Faktoren dar.

Den Anforderungen der Photolithographie genügten beispielsweise lange Zeit naßentwickelbare Einlagenresists, insbesondere solche, welche aus Novolakharzen (als Basispolymer) und Chinondiaziden (als photoaktive Komponente) bestehen. Die zukünftigen Anforderungen, wie die Strukturierung mit Excimerlasersteppern im DUV-Bereich (= Deep UV) zur Erzeugung von Reliefstrukturen unterhalb 0,5 µm mit senkrechten Flanken bei hoher Resistdicke, können derartige Resistsysteme aber kaum mehr oder gar nicht erfüllen; dies gilt insbesondere bei stufigen Substrattopographien und bei hochreflektierenden Unterlagen. Da zur Erzeugung sehr kleiner Strukturen kürzere Belichtungswellenlängen und hohe numerische Aperturen benötigt werden, gerade dies aber den Bereich der Tiefenschärfe verkleinert, ist es nämlich bei naßentwickelbaren Einlagenresists sehr schwierig, bei relativ dicken Resistschichten und unvermeidbaren Schichtdickenschwankungen auf Stufentopographien eine hohe Auflösung zu erzielen. Darüber hinaus sind Systeme der genannten Art für den Einsatz als DUV-Resist ungeeignet, insbesondere wegen der hohen Eigenabsorption von Novolaken, beispielsweise bei 248 nm.

Um die mit der Verwendung von naßentwickelbaren Einlagenresists verbundenen Probleme zu beseitigen, wurden sogenannte Zweilagensysteme entwickelt, die allerdings kompliziert sind. Bei den Zweilagensystemen wird nur eine obere dünne Schicht belichtet und strukturiert, d.h., entwickelt oder durch Behandlung mit einem Agens chemisch verändert, und die hierbei erzeugte Struktur wird anschließend in die untere(n) Schicht(en) übertragen; die obere Schicht dient dabei als Kontaktmaske. Zur Strukturierung der unteren Schicht kann beispielsweise UV-Licht (Flutbelichtung) in Verbindung mit einer Naßentwicklung oder einer Trockenentwicklung, wie reaktives Ionenätzen im Sauerstoffplasma ($O_2$/RIE), dienen.

Aus der EP-OS 0 249 769 ist ein Verfahren zur Erzeugung einer Reliefstruktur unter Verwendung eines Zweilagen-Resistsystems bekannt. Hierbei wird zunächst der obere Resist bildmäßig belichtet und dann entwickelt, wobei eine Resistmaske erhalten wird. Durch diese Resistmaske wird der untere Resist belichtet und dann entwickelt. Anschließend wird der untere Resist, der reaktive funktionelle Wasserstoffgruppen aufweist, mit einem multifunktionellen organometallischen Material behandelt. Dies kann eine siliciumorganische Verbindung (Silan, Silazan, Siloxan) oder eine titanorganische Verbindung sein, die gasförmig oder in flüssiger Phase zur Anwendung gelangt, d.h. gelöst in einem inerten organischen, im allgemeinen aprotischen Lösungsmittel.

Die Vorteile der Zweilagensysteme, bei gleichzeitig geringerer Komplexität, besitzen trockenentwickelbare Einlagensysteme. Bei diesen Systemen wird in einer auf ein Substrat aufgebrachten Resistschicht durch Belichten der Oberfläche ein latentes Bild erzeugt. Dann wird der Resist mit einem metallhaltigen organischen Reagenz behandelt, beispielsweise mit einer Organosiliciumverbindung, wobei - je nach Prozeßführung - entweder nur die belichteten Bereiche (Negativresist) oder nur die unbelichteten Bereiche (Positivresist) mit dem Reagenz reagieren. Durch Ätzen im Sauerstoffplasma erfolgt anschließend eine Trockenentwicklung der nichtsilylierten Bereiche.

Bei der DUV-Lithographie ergibt sich das weitere Problem, daß die Empfindlichkeit von Resists, die Chinondiazide oder aliphatische Diazoketone als photoaktive Komponente enthalten, gering ist und den Anforderungen der Produktion nicht entspricht. Zur Erhöhung der Empfindlichkeit, insbesondere bei der DUV-Lithographie, sind deshalb nach dem Prinzip der sogenannten chemischen Verstärkung ("chemical amplification") arbeitende Systeme entwickelt worden, die sowohl bei naßentwickelbaren Resists (siehe: EP-OS 0 102 450) als auch bei trockenentwickelbaren Resists (siehe: EP-OS 0 161 476 und EP-OS 0 229 917) Anwendung finden.

Bei Systemen der vorstehend genannten Art, die beispielsweise aus tert.-Butoxycarbonyloxystyrol (als Basispolymer) und einem sogenannten "photo acid-generator" (als photoaktive Komponente), d.h. aus einer bei Belichtung eine starke Säure bildenden Verbindung, bestehen, ändert sich - im Gegensatz zu konventionellen Diazoketon/Novolak-Systemen - nach der Belichtung auch die Polarität des Basispolymers. Außerdem spaltet ein Säuremolekül mehrere Schutzgruppen, was ein Charakteristikum der chemischen Verstärkung ist und zu hohen Empfindlichkeiten führt. Bei dieser säurekatalysierten Spaltung, die eine Möglichkeit der chemischen Verstärkung darstellt, können außer Boc-Gruppen (Boc = tert.-Butoxycarbonyl) beispielsweise auch spaltbare Ether als Schutzgruppen eingesetzt werden.

Aus der EP-OS 0 161 476 ist es bekannt, einen aus tert.-Butoxycarbonyloxystyrol und einer photoaktiven Komponente in Form von Triphenylsulfoniumhexafluorarsenat bestehenden Resist mit UV-Licht durch eine Maske zu belichten und im Vakuumofen 1 h mit gasförmigem Hexamethyldisilazan (HMDS) bei 85°C zu behandeln; dabei werden die belichteten Bereiche der Resistoberfläche silyliert. Nach einem Reaktivionenätzen im Sauerstoffplasma und einer Behandlung mit verdünnter, gepufferter Fluorwasserstoffsäure werden hochaufgelöste negative Strukturen mit senkrechten Flanken erhalten. Neben Hexamethyldisilazan sind als mögliche Behandlungsreagenzien auch Trimethylsilylchlorid und Trimethylzinnchlorid genannt. Die Behandlungsreagenzien sollen in der Gasphase oder in einem "geeigneten Lösungsmittel" zum Einsatz gelangen können, hierzu finden sich allerdings keine näheren Angaben.

Aus der EP-OS 0 192 078 ist ein Verfahren zur Erzeugung einer negativen Resiststruktur unter Verwendung eines trockenentwickelbaren Resistsystems bekannt. Dabei wird zunächst auf ein Substrat ein Basispolymer aufgebracht, das einen kationischen Photoinitiator, insbesondere ein Triarylsulfoniumsalz oder ein trihalogeniertes Methyltriazin, enthält. Nach der Belichtung wird die Resistschicht mit einem kationisch polymerisierbaren Monomeren behandelt, um einen Polymerfilm zu bilden, der die belichteten Bereiche beim nachfolgenden Plasmaätzen schützt. Die Behandlung mit dem Monomeren, das insbesondere ein Epoxysiloxan oder -silan oder ein Styrolsilylether ist, kann in der Gasphase oder in Lösung erfolgen.

Bekannt ist ferner ein trockenentwickelbares, nach dem Prinzip der chemischen Verstärkung arbeitendes Negativresistsystem, bei dem nach der Abspaltung einer Boc-Schutzgruppe eine Silylierung mit HMDS erfolgt (siehe dazu: SPIE's 1990 Symposium on Microlithography, 4. bis 9. März 1990, San Jose, Kalifornien, USA: Tagungsband, Seite 101). Aus der EP-OS 0 229 917 ist es zur Erzeugung von positiven Resiststrukturen bekannt, den belichteten Resist zunächst mit einer nicht-metallorganischen Verbindung in Form eines Isocyanats und - nach einer Flutbelichtung - mit einem metallorganischen Reagenz in Form einer Zinn- oder Siliciumverbindung, wie HMDS, zu behandeln und dann trocken zu entwickeln (siehe auch EP-OS 0 251 241).

Bei den vorstehend genannten Systemen ergeben sich jedoch folgende Nachteile:

- Verwendung von feuchteempfindlichen, korrosiven oder giftigen, zumindest aber gesundheitsgefährdenden Gasen oder organischen Lösungsmitteln;
- Bedarf an speziellen evakuierbaren Apparaturen;
- Behandlung bei erhöhter Temperatur;
- komplizierte Prozeßführung und erschwerte Reproduzierbarkeit.

In der DE-OS 39 13 434 bzw. der entsprechenden EP-OS 0 394 740 wird ein negativ arbeitendes, trockenentwickelbares Resistsystem vorgeschlagen, das - im Gegensatz zu vergleichbaren anderen Systemen - eine einfache Handhabung erlaubt, eine hohe Selektivität im Sauerstoffplasma aufweist, zu hochaufgelösten Strukturen mit steilen Flanken führt und in vorhandenen üblichen Apparaturen zur Anwendung gelangen kann. Eine Besonderheit dieses Systems besteht darin, daß die Behandlung des Resists mit einem metallhaltigen organischen Reagenz in einer wäßrigen oder Wasser enthaltenden, nicht-toxischen Phase erfolgt und unter Normalbedingungen, d.h. bei Raumtemperatur und Normaldruck, durchgeführt wird. Dieses Resistsystem, das aus einem Basispolymer mit reaktiven Gruppen, beispielsweise ein Copolymer aus Styrol und Maleinsäureanhydrid, und einer photoaktiven Komponente auf Chinondiazid-Basis besteht, arbeitet nach dem konventionellen Prinzip, d.h. bei der Belichtung, bei der aus dem Chinondiazid eine Carbonsäure entsteht, wird nur die Polarität der photoaktiven Komponente geändert. Aus diesem Grunde ist das vorgeschlagene Resistsystem - bei den derzeit zur Verfügung stehenden Einrichtungen - insbesondere bei der Anwendung in der DUV-Lithographie relativ unempfindlich.

Aufgabe der Erfindung ist es, ein Verfahren zur Erzeugung einer hochaufgelösten Resiststruktur mit steilen Flanken bzw. ein dafür geeignetes trockenentwickelbares Resistsystem anzugeben, das sowohl eine einfache Handhabung erlaubt, eine hohe Selektivität im Sauerstoffplasma besitzt und in vorhandenen üblichen Apparaturen zum Einsatz gelangen kann als auch eine hohe Empfindlichkeit aufweist, insbesondere im DUV-Bereich.

Dies wird erfindungsgemäß dadurch erreicht,

- daß auf ein Substrat eine Photoresistschicht aus einem Polymer, das Anhydridgruppen und blockierte Imid- oder phenolische Hydroxylgruppen enthält, und einer photoaktiven Komponente in Form einer bei Belichtung eine starke Säure bildenden Verbindung aufgebracht wird,
- daß die Photoresistschicht bildmäßig belichtet wird,
- daß die belichtete Photoresistschicht einer Temperaturbehandlung unterworfen wird,
- daß die Photoresistschicht nach der Temperaturbehandlung mit einer wäßrigen oder wäßrig-alkoholischen Lösung eines polyfunktionellen Amino- oder Hydroxysiloxans behandelt wird,

- und daß die derart behandelte Photoresistschicht in einem sauerstoffhaltigen Plasma geätzt wird.

Das erfindungsgemäße Verfahren, das nach dem Prinzip der chemischen Verstärkung arbeitet, nimmt im allgemeinen folgenden Verlauf. Ein Resist, der aus einem Basispolymer und einer photoaktiven Komponente besteht, wird in Form einer Lösung, die gegebenenfalls Zusatzstoffe, wie Sensibilisatoren, enthält, auf eine Unterlage, beispielsweise einen Siliciumwafer, aufgebracht. Das Basispolymer weist chemisch reaktive Gruppen in Form von Anhydridgruppen auf, ist aber dennoch lagerbeständig. Als photoaktive Komponente dienen Verbindungen, die bei Belichtung eine starke Säure bilden. Als derartige Verbindungen dienen vorzugsweise Oniumsalze und halogenhaltige Triazinderivate.

Das Basispolymer weist neben den Anhydridgruppen noch blockierte funktionelle Gruppen auf, und zwar in Form von Imid- oder phenolischen OH-Gruppen. Zur Blockierung dieser Gruppen, d.h. als Schutzgruppe, kann beispielsweise eine Boc-Gruppe dienen. Phenolische OH-Gruppen können beispielsweise aber auch in Form säurespaltbarer Ether geschützt, d.h. blockiert werden. Die bei der Belichtung aus der photoaktiven Komponente gebildete Säure spaltet die Schutzgruppen katalytisch ab, wobei die funktionellen Gruppen freigesetzt werden, d.h. Imid- bzw. phenolische OH-Gruppen. Diese funktionellen Gruppen ermöglichen nachfolgend den selektiven Einbau des Amino- bzw. Hydroxysiloxans, d.h. dessen Diffusion in die Photoresistschicht und eine Reaktion mit den Anhydridgruppen des Basispolymers.

Geeignete Basispolymere sind beispielsweise Copolymere aus tert.-Butoxycarbonyloxystyrol und Maleinsäureanhydrid oder Terpolymere aus tert.-Butoxycarbonyloxystyrol, Maleinsäureanhydrid und Styrol. Als Comonomer für Maleinsäureanhydrid kommen auch säurespaltbare Ether von p-Hydroxystyrol in Betracht, beispielsweise Isopropyl- und tert.-Butylether. Basispolymere mit blockierten Imidgruppen sind beispielsweise Terpolymere aus Maleinsäureanhydrid, Styrol und blockiertem Maleinimid (z.B. mit einer Boc-Schutzgruppe).

Vorteilhaft kann das erfindungsgemäße Verfahren auch in der Weise ausgeführt werden, daß ein Polymer zum Einsatz gelangt, das nur Anhydridgruppen aufweist. Dafür wird dem Polymer dann ein Additiv zugesetzt, welches blockierte funktionelle Gruppen besitzt, und zwar Hydroxylgruppen. Derartige Additive, aus denen mit einer Säure die OH-Gruppen freigesetzt werden, und zwar in den belichteten Bereichen, blockieren die Silylierung der Anhydridgruppen in den unbelichteten Bereichen. Die blockierten OH-Gruppen können in Form von Acetal-, Ketal- oder Orthoestergruppen vorliegen. Die Hydroxylgruppen können auch phenolische OH-Gruppen sein, die dann in der vorstehend angegebenen Weise blockiert sind; dazu können beispielsweise tert.-Butoxyphenyl- und tert.-Butoxycarbonyloxyphenyl-Gruppen dienen. Geeignete Polymere sind beispielsweise Copolymere aus Maleinsäureanhydrid und Styrol. Eine Vielzahl von weiteren geeigneten Polymeren ist in der DE-OS 39 13 434 bzw. EP-OS 0 394 740 aufgeführt.

Nach dem Aufbringen der Resistlösung auf das Substrat wird getrocknet, dann wird durch eine Maske belichtet. Nach der Belichtung wird die Resistschicht einer Temperaturbehandlung unterworfen und nachfolgend mit der Lösung eines polyfunktionellen Amino- oder Hydroxysiloxans behandelt, und zwar unter Verwendung von Standardequipment. Als derartige Organosiliciumverbindungen dienen vorzugsweise Diaminosiloxane; geeignete Verbindungen sind beispielsweise in der DE-OS 39 13 434 bzw. EP-OS 0 394 740 beschrieben. Die Organosiliciumverbindungen gelangen in Form einer Lösung zum Einsatz, und zwar als wäßrige oder wäßrig-alkoholische Lösung, wobei als Alkohol insbesondere Isopropanol dient. Nach der Behandlung mit der Organosiliciumverbindung erfolgt dann noch eine Trockenentwicklung im Sauerstoffplasma ($O_2$/RIE).

Bei der vorstehend geschilderten Vorgehensweise werden negative Resiststrukturen erhalten. Das erfindungsgemäße Verfahren kann aber auch zur Erzeugung positiver Bilder dienen. Dazu wird die Photoresistschicht nach der Temperaturbehandlung, d.h. vor der Behandlung mit der Organosiliciumverbindung, mit einer polyfunktionellen organischen Verbindung behandelt, welche funktionelle Gruppen aufweist, die zu einer chemischen Reaktion mit den Anhydridgruppen des Polymers befähigt sind; anschließend erfolgt dann noch eine Flutbelichtung.

Durch die Behandlung mit der polyfunktionellen organischen Verbindung wird das Basispolymer in den belichteten Bereichen blockiert. Bei der späteren Behandlung mit der Organosiliciumverbindung reagieren dann nur die flutbelichteten Bereiche und werden so gegen Plasmaätzen geschützt. Vor der Flutbelichtung, d.h. einer Belichtung ohne Maske, kann der Resist vorteilhaft einer Temperaturbehandlung unterworfen werden, wozu er kurzfristig, beispielsweise für 90 s, bei Temperaturen im Bereich von 100°C, beispielsweise bei 110°C, getempert wird. Nach der Flutbelichtung erfolgt dann die Behandlung mit der Organosiliciumverbindung und anschließend das Plasmaätzen.

Als polyfunktionelle organische Verbindung, d.h. als metallfreie Verbindung, wird beim erfindungsgemäßen Verfahren vorzugsweise ein Polyamin verwendet, d.h. eine Verbindung mit wenigstens zwei Aminogruppen; vorteilhaft dienen dazu aliphatische Polyamine, auch solche mit aromatischen Partialstrukturen. Geeignete polyfunktionelle Amine sind beispielsweise Triethylentetramin, Tetraethylenpentamin, Tris(2-aminoethyl)-amin, N.N'-Bis(3-aminopropyl)-1.2-ethylendiamin und 3-(Aminomethyl)-benzylamin. Diese Verbindungen, die als Vernetzungsreagenzien dienen, gelangen vorteilhaft in Form wäßriger Lösungen zum Einsatz.

Die Erfindung kann vorteilhaft nicht nur bei Einlagensystemen, sondern auch bei - trockenentwickelbaren - Zweilagensystemen Anwendung finden. Der reaktive Resist wird dabei, als dünne Lage, auf eine trockenätzbare Planarisierungsschicht aufgebracht, die - je nach den Anforderungen - frei wählbar ist. Im übrigen dient als Unterlage, d.h. als Substrat, im allgemeinen Halbleitermaterial, Metall, Keramik oder dergleichen.

Anhand von Ausführungsbeispielen soll die Erfindung noch näher erläutert werden. Zur Durchführung des erfindungsgemäßen Verfahrens dienen dabei folgende Ausgangsmaterialien bzw. Behandlungsreagenzien (MT = Masseteile):

- Basispolymer (1):
  Copolymer aus Maleinsäureanhydrid und 4-(tert.-Butoxycarbonyloxy)-styrol, hergestellt durch radikalische Polymerisation der beiden Monomeren mit Azoisobuttersäurenitril als Initiator und einem Alkylmercaptan als Regler.
- Basispolymer (2):
  Copolymer aus Maleinsäureanhydrid und 4-(tert.-Butoxycarbonyloxy)-styrol, hergestellt durch radikalische Polymerisation der beiden Monomeren mit Azoisobuttersäurenitril als Initiator (ohne Regler).
- Basispolymer (3):
  Copolymer aus Maleinsäureanhydrid und 4-(tert.-Butoxy)-styrol, hergestellt durch radikalische Polymerisation der beiden Monomeren mit Azoisobuttersäurenitril als Initiator und einem Alkylmercaptan als Regler.
- Basispolymer (4):
  Terpolymer aus Maleinsäureanhydrid, 4-(tert.-Butoxycarbonyloxy)-styrol und Styrol, hergestellt durch radikalische Polymerisation der drei Monomeren mit Azoisobuttersäurenitril als Initiator und einem Alkylmercaptan als Regler.
- Basispolymer (5):
  Copolymer aus Maleinsäureanhydrid und Styrol, hergestellt durch radikalische Polymerisation der beiden Monomeren mit Azoisobuttersäurenitril als Initiator und einem Alkylmercaptan als Regler.
- Photoaktive Komponente (1):
  Dies ist eine Verbindung, die bei Belichtung eine starke Säure bildet; geeignete Säurebildner sind insbesondere die als Crivello-Salze bekannten Oniumverbindungen und Triazinderivate; zum Einsatz gelangt Bis[4-(diphenylsulfonium)-phenyl]-sulfid-bis-hexafluorantimonat.
- Additiv (1):
  Dies ist eine Verbindung, aus der mit einer starken Säure wenigstens eine Hydroxylgruppe freigesetzt wird; zum Einsatz gelangt 4-(tert.-Butoxycarbonyloxy)-diphenylmethan.
- Silylierungslösung (1):
  Wäßrig-alkoholische Lösung, bestehend aus 4 MT Diaminosiloxan, 82,3 MT Isopropanol und 13,7 MT Wasser; vorzugsweise wird ein $\alpha,\omega$-aminofunktionelles Siloxan, insbesondere mit zwei endständigen Aminopropylgruppen und 2 bis 20 Siliciumatomen in der Kette, verwendet, beispielsweise das handelsübliche Produkt Tegomer A-Si 2120 (Fa. Goldschmidt).
- Silylierungslösung (2):
  Wäßrig-alkoholische Lösung, bestehend aus 2 MT Diaminosiloxan (Tegomer A-Si 2120), 78,4 MT Isopropanol und 19,6 MT Wasser.
- Silylierungslösung (3):
  Wäßrig-alkoholische Lösung, bestehend aus 1 MT Diaminosiloxan (Tegomer A-Si 2120), 79,2 MT Isopropanol und 19,8 MT Wasser.
- Vernetzungslösung (1):
  Wäßrige Lösung, bestehend aus 2 MT Tris (2-aminoethyl)-amin und 98 MT Wasser.

Beispiel 1

Auf einen Siliciumwafer wird ein Resist, bestehend aus 17,1 MT Basispolymer (2), 0,9 MT photoaktive Komponente (1) und 82 MT Cyclohexanon, aufgeschleudert (2500 rpm, 20 s). Nach Trocknung bei 100°C/60 s auf einer Hotplate beträgt die Schichtdicke dieses Resists 1,1 µm. Der Resist wird dann durch eine Maske mit 15 mJ/cm$^2$ kontaktbelichtet (Gerät MJB 3 / Karl Süss: $\lambda$ = 250 nm), 60 s bei 110°C getempert, 30 s mit der Silylierungslösung (1) behandelt und 30 s mit Isopropanol gespült. Anschließend wird der Siliciumwafer in eine Plasmaätzanlage (Material Research Corporation, Typ MIE 720) gebracht und der Resist im Sauerstoffplasma trocken entwickelt ($O_2$/RIE: 2 mTorr Gasdruck, 50 V Biasspannung, mit Magnet). Es werden negative Strukturen bis 0,3 µm mit senkrechten Flanken erhalten.

Beispiel 2

Auf einen Siliciumwafer wird der käufliche Positivresist TSMR 8900 (Fa. Tokyo Ohka Kogyo Co.) aufgeschleudert (4000 rpm, 20 s) und 5 min bei 90°C getrocknet; dann wird 35 min im Umluftofen bei 240°C ausgeheizt. Nach dem Ausheizen beträgt die Dicke des als Planarisierungsschicht dienenden Resists 1,3 µm.

Auf die Planarisierungsschicht wird ein Resist, bestehend aus 15,2 MT Basispolymer (1), 0,8 MT photoaktive Komponente (1) und 84 MT Cyclohexanon, aufgeschleudert (4500 rpm, 20 s). Nach Trocknung bei 100°C/60 s auf einer Hotplate beträgt die Schichtdicke dieses Topresists 440 nm. Der Resist wird dann durch eine Maske mit 13 mJ/cm$^2$ kontaktbelichtet (Gerät MJB 3/Karl Süss: $\lambda$ = 250 nm), 60 s bei 110°C getempert, 30 s mit der Silylierungslösung (1) behandelt und 30 s mit Isopropanol gespült. Anschließend wird der Siliciumwafer in eine Plasmaätzanlage (Leybold Heraeus, Typ Z 401) gebracht und der Resist im Sauerstoffplasma trocken entwickelt ($O_2$/RIE: 6 mTorr Gasdruck, 500 V Biasspannung). Es werden negative Strukturen bis 0,3 µm mit senkrechten Flanken und einem Steg/Graben-Verhältnis von 1:1 erhalten.

Beispiel 3

Ein Resist, bestehend aus 14,9 MT Basispolymer (3), 1,1 MT photoaktive Komponente (1) und 84 MT Cyclohexanon, wird auf eine Planarisierungsschicht entsprechend Beispiel 2 aufgeschleudert (3000 rpm, 20 s). Nach Trocknung bei 100°C/60 s auf einer Hotplate beträgt die Schichtdicke dieses Topresists 400 nm. Der Resist wird dann durch eine Maske mit 13 mJ/cm$^2$ kontaktbelichtet (Gerät MJB 3 / Karl Süss: $\lambda$ = 250 nm), 60 s bei 110°C getempert, 45 s mit der Silylierungslösung (2) behandelt und 30 s mit Isopropanol gespült. Nach Trockenentwicklung (O$_2$/RIE: 2 mTorr Gasdruck, 50 V Biasspannung, mit Magnet) in einer Plasmaätzanlage (Material Research Corporation, Typ MIE 720) werden gut aufgelöste negative Strukturen bis 0,3 µm mit steilen Flanken erhalten.

Beispiel 4

Ein Resist, bestehend aus 20,9 MT Basispolymer (4), 1,1 MT photoaktive Komponente (1) und 78 MT Cyclohexanon, wird auf einen Siliciumwafer aufgeschleudert (3000 rpm, 20 s). Nach Trocknung bei 100°C/60 s auf einer Hotplate beträgt die Schichtdicke dieses Resists 1,2 µm. Der Resist wird dann durch eine Maske mit 14 mJ/cm$^2$ kontaktbelichtet (Gerät MJB 3 / Karl Süss: $\lambda$ = 250 nm), 75 s bei 110°C getempert, 60 s mit der Silylierungslösung (3) behandelt und 30 s mit Isopropanol gespült. Anschließend wird der Siliciumwafer in eine Plasmaätzanlage (Material Research Corporation, Typ MIE 720) gebracht und der Resist im Sauerstoffplasma trocken entwickelt (O$_2$/RIE: 2 mTorr Gasdruck, 50 V Biasspannung, mit Magnet). Es werden negative Strukturen bis 0,35 µm mit steilen Flanken und einem Steg/Graben-Verhältnis von 1:1 erhalten.

Beispiel 5

Ein Resist entsprechend Beispiel 2 wird in der dort beschriebenen Weise auf die Unterlage aufgebracht und getrocknet und dann durch eine Maske mit 8 mJ/cm$^2$ kontaktbelichtet (Gerät MJB 3 / Karl Süss: $\lambda$ = 250 nm) und 75 s bei 110°C getempert. Anschließend wird 60 s mit der Vernetzungslösung (1) behandelt, 30 s mit Wasser gespült und 90 s bei 110°C getempert. Durch diesen Prozeß werden die belichteten Bereiche so stark vernetzt, daß bei der nachfolgenden Behandlung mit der Organosiliciumverbindung keine Silylierung dieser Bereiche erfolgt.

Nach einer DUV-Flutbelichtung (ohne Maske) mit 12 mJ/cm$^2$ wird der Resist 30 s bei 100°C getempert, 35 s mit der Silylierungslösung (1) behandelt und dann 30 s mit Isopropanol gespült. Anschließend wird in einer Plasmaätzanlage (Leybold Heraeus, Typ Z 401) im Sauerstoffplasma trocken entwickelt (O$_2$/RIE: 6 mTorr Gasdruck, 450 V Biasspannung). Es werden positive Strukturen mit senkrechten Flanken und einem Steg/Graben-Verhältnis von 1:1 erhalten.

Beispiel 6

Ein Resist, bestehend aus 9,7 MT Basispolymer (5), 4,5 MT Additiv (1), 0,8 MT photoaktive Komponente (1) und 85 MT Cyclohexanon, wird auf eine Planarisierungsschicht entsprechend Beispiel 2 aufgeschleudert (4500 rpm, 20 s). Nach Trocknung bei 90°C/60 s auf einer Hotplate beträgt die Schichtdicke dieses Topresists 300 nm. Der Resist wird dann durch eine Maske mit 16 mJ/cm$^2$ kontaktbelichtet (Gerät MJB 3 / Karl Süss: $\lambda$ = 250 nm), 60 s bei 110°C getempert, 30 s mit der Silylierungslösung (2) behandelt und 30 s mit Isopropanol gespült. Nach Trockenentwicklung (O$_2$/RIE: 6 mTorr Gasdruck, 500 V Biasspannung) in einer Plasmaätzanlage (Leybold Heraeus, Typ Z 401) werden negative Strukturen bis 0,3 µm mit senkrechten Flanken erhalten.

**Patentansprüche**

1. Verfahren zur Erzeugung einer hochaufgelösten Reststruktur mit steilen Flanken, **dadurch gekennzeichnet**,

   - daß auf ein Substrat eine Photoresistschicht aus einem Anhydridgruppen und blockierte Imid- oder phenolische Hydroxylgruppen enthaltenden Polymer und einer photoaktiven Komponente in Form einer bei Belichtung eine starke Säure bildenden Verbindung aufgebracht wird,
   - daß die Photoresistschicht bildmäßig belichtet wird,
   - daß die belichtete Photoresistschicht einer Temperaturbehandlung unterworfen wird,
   - daß die Photoresistschicht nach der Temperaturbehandlung mit einer wäßrigen oder wäßrig-alkoholischen Lösung eines polyfunktionellen Amino- oder Hydroxysiloxans behandelt wird,
   - und daß die derart behandelte Photoresistschicht in einem sauerstoffhaltigen Plasma geätzt wird.

2. Verfahren zur Erzeugung einer hochaufgelösten Reststruktur mit steilen Flanken, **dadurch gekennzeichnet**,

   - daß auf ein Substrat eine Photoresistschicht aus einem Anhydridgruppen enthaltenden Polymer, einem blockierte Hydroxylgruppen enthaltenden Additiv und einer photoaktiven Komponente in Form einer bei Belichtung eine starke Säure bildenden Verbindung aufgebracht wird,

- daß die Photoresistschicht bildmäßig belichtet wird,
- daß die belichtete Photoresistschicht einer Temperaturbehandlung unterworfen wird,
- daß die Photoresistschicht nach der Temperaturbehandlung mit einer wäßrigen oder wäßrig-alkoholischen Lösung eines polyfunktionellen Amino- oder Hydroxysiloxans behandelt wird,
- und daß die derart behandelte Photoresistschicht in einem sauerstoffhaltigen Plasma geätzt wird.

3. Verfahren nach Anspruch 1 oder 2, **dadurch gekennzeichnet**, daß als photoaktive Komponente ein Oniumsalz oder ein halogenhaltiges Triazinderivat verwendet wird.

4. Verfahren nach einem der Ansprüche 1 bis 3, **dadurch gekennzeichnet**, daß die Photoresistschicht nach der Temperaturbehandlung mit einer polyfunktionellen organischen Verbindung mit funktionellen Gruppen, die zu einer chemischen Reaktion mit den Anhydridgruppen des Polymers befähigt sind, behandelt wird, und daß nachfolgend eine Flutbelichtung erfolgt.

5. Verfahren nach Anspruch 4, **dadurch gekennzeichnet**, daß die Photoresistschicht vor der Flutbelichtung einer Temperaturbehandlung unterworfen wird.

6. Verfahren nach Anspruch 4 oder 5, **dadurch gekennzeichnet**, daß als polyfunktionelle organische Verbindung ein Polyamin verwendet wird.

7. Verfahren nach Anspruch 6, **dadurch gekennzeichnet**, daß ein aliphatisches Polyamin verwendet wird.

8. Verfahren nach einem oder mehreren der Ansprüche 1 bis 7, **dadurch gekennzeichnet**, daß die Photoresistschicht auf eine trockenätzbare Planarisierungsschicht aufgebracht wird.

**Claims**

1. Method for producing a highly resolved resist structure with steep edges, characterized in that

- a photoresist layer consisting of a polymer which contains anhydride groups and blocked imide or phenolic hydroxyl groups, and of a photoactive component in the form of a compound forming a strong acid during exposure is applied to a substrate,
- the photoresist layer is exposed patternwise,
- the exposed photoresist layer is subjected to a temperature treatment,
- the photoresist layer after the temperature treatment is treated with an aqueous or aqueous-alcoholic solution of a polyfunctional amino-siloxane or hydroxy-siloxane,
- and the photoresist layer treated in this way is etched in a plasma containing oxygen.

2. Method for producing a highly resolved resist structure with steep edges, characterized in that

- a photoresist layer consisting of a polymer which contains anhydride groups, of an additive containing blocked hydroxyl groups and of a photoactive component in the form of a compound forming a strong acid during exposure is applied to a substrate,
- the photoresist layer is exposed patternwise,
- the exposed photoresist layer is subjected to a temperature treatment,
- the photoresist layer after the temperature treatment is treated with an aqueous or aqueous-alcoholic solution of a polyfunctional amino-siloxane or hydroxy-siloxane,
- and the photoresist layer treated in this way is etched in a plasma containing oxygen.

3. Method according to claim 1 or 2, characterized in that an onium salt or a triazine derivative containing halogen is used as photoactive component.

4. Method according to one of claims 1 to 3, characterized in that the photoresist layer after the temperature treatment is treated with a polyfunctional organic compound with functional groups which are capable of a chemical reaction with the anhydride groups of the polymer, and in that subsequently a flood exposure takes place.

5. Method according to claim 4, characterized in that before the flood exposure the photoresist layer is subjected to a temperature treatment.

6. Method according to claim 4 or 5, characterized in that a polyamine is used as polyfunctional organic compound.

7. Method according to claim 6, characterized in that an aliphatic polyamine is used.

8. Method according to one or more of claims 1 to 7, characterized in that the photoresist layer is applied to a dry-etchable planarization layer.

## Revendications

1. Procédé pour réaliser une structure de réserve de haute résolution avec des flancs abrupts, caractérisé en ce que,

   - on dépose sur un substrat, une couche d'une photoréserve constituée d'un polymère contenant des radicaux anhydride et des radicaux imide bloqués ou hydroxyle phénolique bloqués et d'un composant photoactif sous forme d'un composé formant un acide fort par irradiation,
   - la couche de la photoréserve est exposée sous forme d'image,
   - la couche de la photoréserve exposée est soumise à un traitement thermique,
   - la couche de la photo réserve est traitée, après le traitement thermique, par une solution aqueuse ou aqueuse-alcoolique d'un amino- ou hydroxysiloxane polyfonctionnel,
   - et en ce que la couche de la photoréserve ainsi traitée est attaquée dans un plasma contenant de l'oxygène.

2. Procédé pour réaliser une structure de réserve de haute résolution avec des flancs abrupts, caractérisé en ce que,

   - on dépose sur un substrat, une couche d'une photoréserve constituée d'un polymère contenant des radicaux anhydride, d'un additif contenant des radicaux hydroxyle bloqués et d'un composant photoactif sous forme d'un composé formant un acide fort par exposition,
   - la couche de la photoréserve est exposée sous forme d'image,
   - la couche de la photoréserve exposée est soumise à un traitement thermique,
   - la couche de la photoréserve est traitée, après le traitement thermique, par une solution aqueuse ou aqueuse-alcoolique d'un amino- ou hydroxysiloxane polyfonctionnel,
   - et en ce que la couche de la photoréserve ainsi traitée est attaquée dans un plasma contenant de l'oxygène.

3. Procédé suivant la revendication 1 ou 2, caractérisé en ce que l'on utilise comme composant photoactif, un sel d'onium ou un dérivé halogéné de la triazine.

4. Procédé suivant l'une quelconque des revendications 1 à 3, caractérisé en ce que la couche de la photoréserve est traitée, après le traitement thermique, avec un composant organique polyfonctionnel avec des radicaux fonctionnels qui sont susceptibles de réagir chimiquement avec les radicaux anhydride du polymère, et en ce qu'elle subit ensuite une exposition par projection.

5. Procédé suivant la revendication 4, caractérisé en ce que la couche de la photoréserve est soumise à un traitement thermique avant l'exposition par projection.

6. Procédé suivant la revendication 4 ou 5, caractérisé en ce que l'on utilise une polyamine comme composé organique polyfonctionnel.

7. Procédé suivant la revendication 6, caractérisé en ce que l'on utilise une polyamine aliphatique.

8. Procédé suivant l'une ou plusieurs des revendications 1 à 7, caractérisé en ce que la couche de la photoréserve est déposée sur une couche de planarisation susceptible d'être attaquée à sec.